# EUROPÄISCHE PATENTSCHRIFT

(11) **EP 1 060 399 B1**
(45) Veröffentlichungstag und Bekanntmachung des Hinweises auf die Patenterteilung: **23.01.2002**
(21) Anmeldenummer: 99907322.4
(22) Anmeldetag: 17.02.1999
(51) Int. Cl.: G01R 31/00

(54) **EMV-PRÜFEINRICHTUNG FÜR GROSSE RÄUMLICH AUSGEDEHNTE SYSTEME**
DEVICE FOR TESTING THE ELECTROMAGNETIC COMPATIBILITY OF SYSTEMS HAVING LARGE DIMENSIONS
DISPOSITIF DE CONTROLE DE LA COMPATIBILITE ELECTROMAGNETIQUE POUR SYSTEMES D'UN GRAND ENCOMBREMENT

(30) Priorität: 18.02.1998 DE 19806696
(43) Veröffentlichungstag der Anmeldung: 20.12.2000
(73) Patentinhaber: Wilbert, Jan, 82024 Taufkirchen (DE); Schwarz, Harald, 03054 Cottbus (DE)
(72) Erfinder: Wilbert, Jan, 82024 Taufkirchen (DE); Schwarz, Harald, 03054 Cottbus (DE)
(86) Internationale Anmeldenummer: DE9900369
(87) Internationale Veröffentlichungsnummer: WO9942849

(56) Entgegenhaltungen:
- EP-A- 0 454 128
- PEIER D ET AL: "KOMPAKTE TEM-ZELLE FUR EMV-TESTS UNTER HOHEN FELDSTARKEN" ELEKTROTECHNISCHE ZEITSCHRIFT - ETZ, Bd. 110, Nr. 3, 1. Februar 1989, Seiten 102-104, XP000039770
- SCHUETTE A: "NANOSEKUNDEN-IMPULSE FUER DIE EMV-PRUEFTECHNIK" ELEKTROTECHNISCHE ZEITSCHRIFT - ETZ, Bd. 114, Nr. 4, 1. Februar 1993, Seiten 270-272, 274 - 27, XP000350028

## Beschreibung

Die Erfindung geht von einer Vorrichtung zur elektromagnetischen Verträglichkeits (EMV)-Störfestigkeitsprüfung aus.
Es ist insbesondere im militärischen Bereich **bekannt,** daß EMV- Störfestigkeitsprüfungen basierend auf einer pulsförmigen kurzen Anregung vorgenommen werden. Bei diesen Prüfungen kommen jedoch weitaus stärkere inhomogenere Felder zur Anwendung. Durch die übliche Gestaltung der Wellenleiter von der Quelle bis zur Senke des Impulses, kann kein für zivile Anforderungen optimales Prüffeld erzeugt werden. Knicke im Wellenleiter, Geometrieänderungen des Wellenleiters von der Quelle bis zur Senke bzgl. seines Rückleiters, eine schlechte Anpassung zwischen den Prüflingsabmessungen bzw. Prüflingsform und dem Prüfraum, die Anordnung des Ladeteils im Prüfraum und den dadurch entstehenden Prüfraumverlust, im Winkel zum Wellenleiter angeordneten schienenförmigen und anderen Funkenstrecken zwischen Impulsquelle und felderzeugendem Wellenleiter die sich in der Geometrie vom Wellenleiter stark unterscheiden, führen zu Reflexionen die, die Ausbreitung des Pulses negativ beeinflussen und so zu einer Verschlechterung des erzeugten elektromagnetischen Feldes im Prüfraum führen. Des weiteren führen zu lange Wellenleiter, wie in vielen Anlagen üblich, zu einer Verschleifung des Pulses bzw. Abstrahlung der Energie und schränken damit sein Frequenzspektrum ein.

Typische Beispiele für die oben genannten Eigenschaften finden sich in der Patentbeschreibung EP-A-0 454 128 und in Veröffentlichungen von D. Peier "Kompakte TEM-Zelle für EMV-Tests unter hohen Feldstärken" und von A. Schütte "NanosekundenImpulse für die EMV-Prüftechnik".

Bei sinusförmig gespeisten Wellenleitern oder Streifenleitern treten dimensionierungsbedingt Frequenzbereichsbeschränkungen auf. Auch mit anderen ähnlichen Prüfmethoden, wie die Benutzung von Antennen mit einer bestimmten Richtcharakteristik in einer entsprechend dimensionierten Absorberkammer, wie sie in der KFZ-Technik üblich sind, ist keine, für größere Systeme ökonomisch zu vertretende Prüfung gegen elektromagnetisch gestrahlte Felder möglich. Insbesondere existiert zur Zeit kein spezieller Störfestigkeitstest für einen gesamten Zug.

Auch gehören Burst-Generatoren, welche Nanosekundenimpulse (5/50ns) in schneller Aufeinanderfolge und über steuerbare Funkenstrecken mit unterschiedlichen Amplituden erzeugen zum Stand der Technik (DE 43 40 514 C2). Diese können jedoch konstruktionsbedingt keine im oben genannten Patentanspruch beschriebene Prüfeinrichtung für große Systeme ersetzen, sondern dienen eher dem leitungsgeführten Komponententest.

Die mit der Erfindung erzielten Vorteile bestehen insbesondere aus der enormen Zeitersparnis in der Prüfzeit, der erzielten Feldqualität und der durch den modularen Aufbau erreichten Anwendbarkeit für beliebig lange Prüflinge bei gleichzeitiger minimaler Länge eines einzelnen pulsführenden Wellenleiters. Zur Prüfung eines gesamten Zuges im Fernfeld, ohne ein Bewegen der Strahlungsquelle, unter Beibehaltung der Feldhomogenität kann mit einer Wellenleiterbreite die sich nur wenig von der Zugbreite unterscheidet, durchgeführt werden.

Der im Patentanspruch angegebenen Erfindung liegt das **Problem** zugrunde, überhaupt für ein großes Gesamtsystem, ein nach anerkannten Regeln der zivilen EMV-Störfestigkeitsprüftechnik [ENV 50140] homogenes Prüffeld zu schaffen.

Dieses Problem wird durch die im Patentanspruch 1 aufgeführten Merkmale, mehrere dieser IEW, IFW, Rückleiter und Abschlußwiderstände in der beschriebenen Anordnung zusammengestellten Einheiten, über eine gemeinsamen Auslösemechanismus parallel modular zusammenzuschalten und damit einen für ein großes System anwendbaren Prüfraum zu bilden **gelöst**.

Die mit der Erfindung erzielten **Vorteile** bestehen insbesondere darin, daß statt der zu falschen Ergebnissen führenden scheibenweisen EMV-Störfestigkeitsprüfung eines großen Systems, wie zivil bisher angewendet, eine komplette Illumination des Prüflings auf einmal in Nanosekunden oder wenigen Sekunden bei repetierenden Betrieb zu ermöglichen. Durch Beibehaltung des Wellenwiderstandes wird ein Prüffeld mit außerordentlicher Qualität erzeugt.

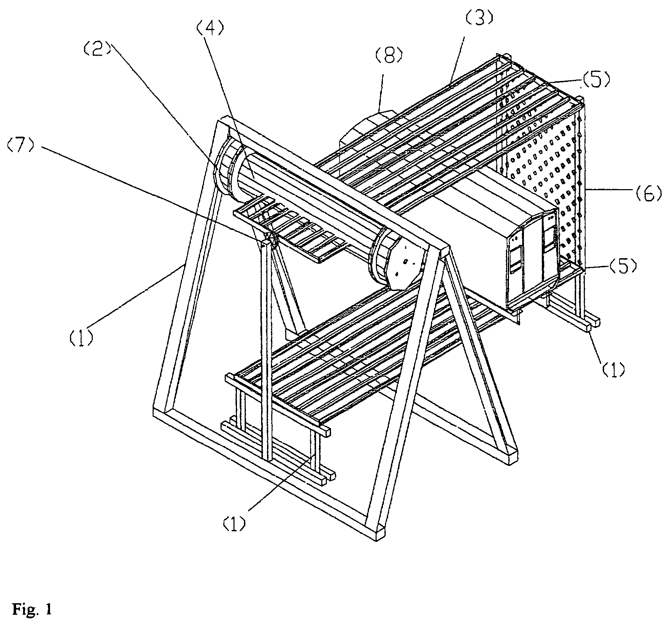

Der große **Prüfraum** ergibt sich durch Parallelschaltung des in Fig. 1 gezeigten Moduls mit baugleichen weiteren Modulen. Eine Änderung der Feldpolarisation kann durch Drehen der Anordnung um die Prüflingslängsachse erreicht werden.

### Impulserzeugung

Der IEW ist zunächst ungeladen. Über eine getriggerte Zündfunkenstrecke wird der IEW oder alle parallel geschalteten IEW gleichzeitig durch eine Hochspannungsquelle auf eine Spannung U₀ (bevorzugt Gleichspannung) aufgeladen. Die Zündfunkenstrecke verlischt aufgrund der sich ergebenden Potentialgleichheit und des daraus resultierenden Rückganges der Stromstärke. Der Impuls wird selbständig nach ca. 100 ms durch Schließen der Rail-Gap mittels vieler kleiner Entladungskanäle, welche den IEW mit dem IFW als Last verbinden, ausgelöst. Mit Hilfe der schienenförmigen Funkenstrecke entsteht eine gleichmäßige Beaufschlagung des IFW mit dem Puls. Die max. Breite der schienenförmigen Funkenstrecke und damit auch der Breite eines Moduls ergibt sich aus fertigungstechnischen Möglichkeiten.

Bei der sonst üblichen Erregung eines Wellenleiters an einem Punkt führt dies durch die unterschiedliche Leiterlänge zu einer zeitlichen Verzögerung des Stromes auf den einzelnen Wellenleitern. Diese zeitliche Verschiebung der Welle auf den unterschiedlichen Stäben führt, wie die Induktivität der Funkenstrecke, und die Änderung des Wellenwiderstandes zu einer Verschleppung der Flanken des Rechteckimpulses und damit zu einem Verlust an Breitbandigkeit des erzeugten Frequenzspektrums.

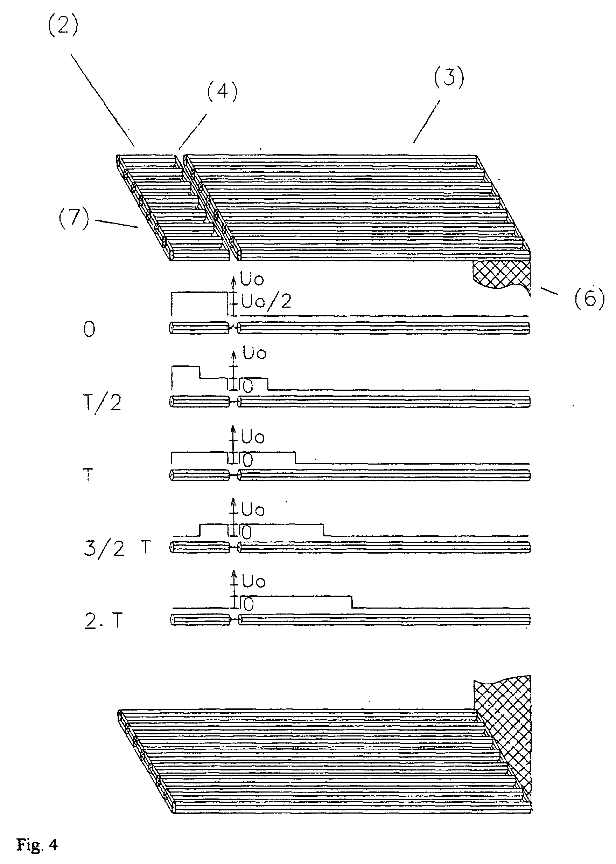

Im Falle der schienenförmigen Funkenstrecke wird die Last an die Impedanz des Ladeteils angepaßt. Dadurch beträgt der Anfangswert der Spannung genau U₀/2. Durch den Spannungssprung von U₀ auf U₀/2 wird eine Wanderwelle erzeugt, welche in Richtung IEW-Anfang läuft. Nach der Laufzeit τ des eingesetzten Wellenleiters erreicht die Wanderwelle den IEW-Anfang, wird an der hochohmigen Funkenstrecke fast vollständig reflektiert (rᵤ = 1) und läßt eine resultierende Spannung Null entstehen. Nach der doppelten Laufzeit 2 τ erreicht die Welle wieder das IEW- Ende. Dieses ist bei gezündeter Funkenstrecke reflexionsfrei (rᵤ = 0) abgeschlossen. Es entsteht auf dem IFW ein Spannungsimpuls. Dieser springt zum Schaltzeitpunkt von Null auf U₀/2 und nach 2 τ wieder auf Null (Fig. 4).

### Feldqualität

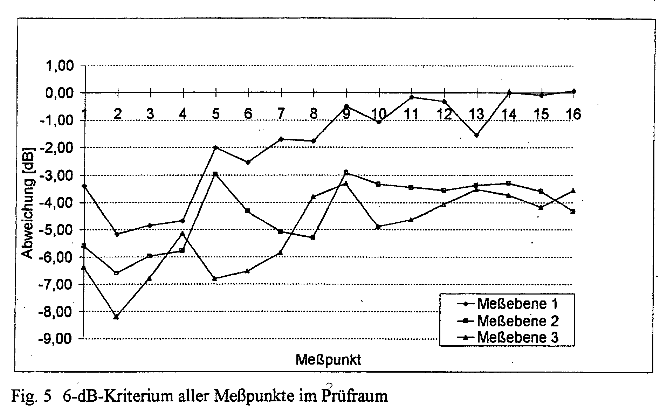

Der gesamte Prüfraum erfüllt in Anlehnung die Forderung der ENV 50 140 und **eignet sich** bzgl. der Feldhomogenität zur **Störfestigkeitsprüfung**. Ein über die Anforderungen der ENV 50140 hinausgehender Vergleich zwischen den drei Ebenen im Prüfraum zeigt die in Fig. 5 dargestellte Variation zwischen dem Punkt 14 als Bezugspunkt und jeweils allen anderen Meßpunkten (6 von 12 möglichen Punkten überschreiten das 6-dB-Kriterium).

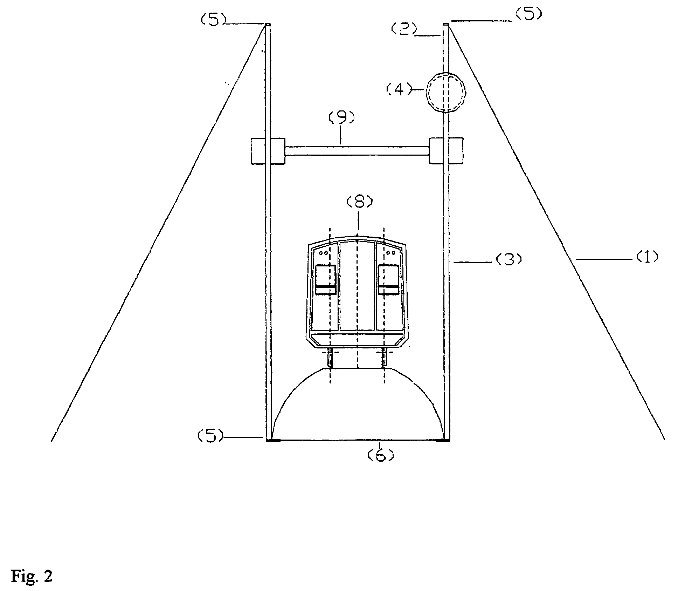

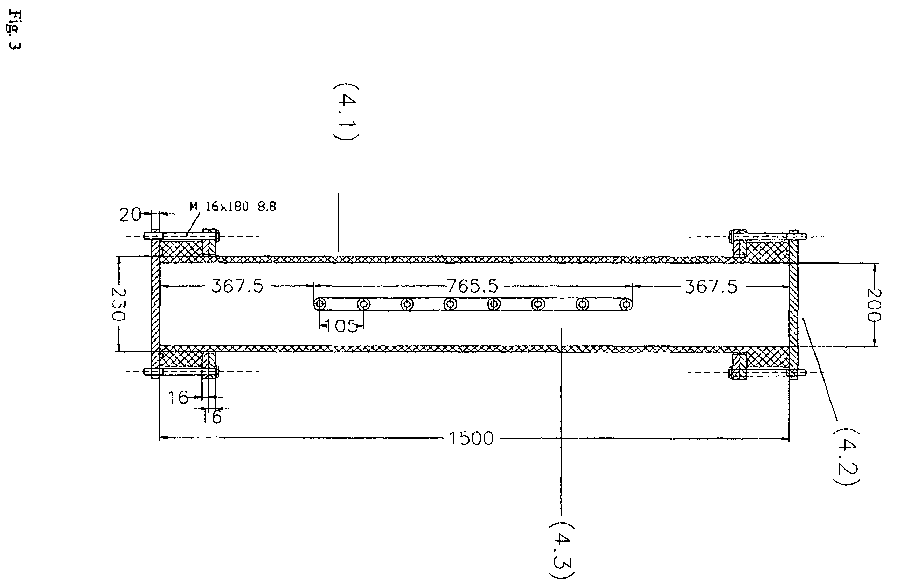

Anhand der Zeichnungen, in der ein Ausführungsbeispiel der Erfindung dargestellt ist, sollen die Erfindung sowie weitere vorteilhafte Ausgestaltung näher Erläutert werden. Es zeigen:
- Fig. 1: Ein Ausführungsbeispiel eines Moduls mit Tragegestell, Hochspannungsanschluß und Prüflingsausschnitt in vertikaler Polarisation
(1) Gestell aus elektrisch nicht leitendem Material
(2) IEW
(3) IFW
(4) Druckrohr und Schienenförmige Funkenstrecke
(5) Sammelschiene
(6) Abschlußwiderstand
(7) Getriggerte erste Zündfunkenstrecke und Hochspannungsquellenanschluß
- Fig. 2: Ein Ausführungsbeispiel für die horizontale Polarisation
(1) Holzgestell
(2) IEW
(3) IFW
(4) Druckrohr und Schienenförmige Funkenstrecke
(5) Sammelschiene
(6) Abschlußwiderstand
(7) Getriggerte erste Zündfunkenstrecke und Hochspannungsquellenanschluß
(8) Zugausschnitt im Prüfraum
(9) Kunststoffstützer
- Fig. 3: Ein Ausführungsbeispiel der Druckröhre mit Elektrode als Detail von Fig. 1 und Fig. 2
(4.1) GFK Röhre
(4.2) Deckel
(4.3)Schienenförmige Elektrode, dient gleichzeitig als Halterung für die einzelnen Wellenleiter
- Fig. 4: Funktionsdarstellung der Impulserzeugung
(2) IEW
(3) IFW
(4) Schienenförmige Funkenstrecke
(6) Abschußwiderstand
- Fig. 5: 6-dB-Kriterium aller Meßpunkte im Prüfraum

## Patentansprüche

1. Vorrichtung zur elektromagnetischen Verträglichkeits (EMV)-Störfestigkeitsprüfung, insbesondere von vergleichsweise räumlich großen Systemen, wie Eisenbahnwagen und/oder Züge, mit impulserzeugenden Wellenleitern (IEW), die parallel zueinander angeordnete, über eine Kopfelektrode (5) zusammengeschaltete elektrisch leitende Einzelstäbe (2) aufweist, die über eine schienenförmige Funkenstrecke (4) in gerader Linie mit impulsfortleitenden Wellenleitern (IFW) verbindbar sind, die ihrerseits zur Bildung eines Prüfraums für das zu prüfende System vorzugsweise rechtwinklig anschließend, mit einem Abschlußwiderstand (6) verbunden sind, der wiederum vorzugsweise rechtwinklig anschließend, mit einem oder mehreren Rückleitern zusammengeschaltet ist, wobei der Betrag des Abschlußwiderstandes (6) mit höchstens wenigen Ohm Differenz dem der impulserzeugenden Wellenleiter (IEW) entspricht.

2. Vorrichtung nach Anspruch 1, **dadurch gekennzeichnet, daß** der Abschlußwiderstand (6) flächig ausgebildet ist oder aus mehreren Einzelwiderständen besteht.

3. Vorrichtung nach Anspruch 1 oder 2, **dadurch gekennzeichnet, daß** mehrere der Vorrichtungen als Module zur Verlängerung des Prüfraumes zusammengeschaltet sind.

4. Vorrichtung nach Ansprüchen 1-3, **dadurch gekennzeichnet, daß** die schienenförrnige Funkenstrecke (4) in einem mit Druck beaufschlagbaren Rohr vorgesehen ist.

5. Vorrichtung nach Ansprüchen 1-4, **dadurch gekennzeichnet, daß** die Prüfung der Systeme im Bereich von Nanosekunden bis Sekunden repetierend durchführbar ist.

6. Vorrichtung nach Anspruch 1, **dadurch gekennzeichnet, daß** die impulserzeugenden Wellenleiter (IEW) parallel zu den Rückenleitern mit im wesentlichen gleichem Wellenwiderstand wie der impuls fort leitende Wellenleiter (IFW) angeordnet sind.

## Claims

1. Device for testing the electromagnetic compatibility and (EMC)-susceptibility, especially for systems having comparatively large dimensions as wagons and/or trains, with impulse generating wave guides (IGW) which are arranged parallel and show electrical conducting single rods (2) switched together over an head electrode (5), which are connectable over a rail-shaped spark gap (4) in direct line with impulse-conducting wave guides (ICW), which, in return, are connected preferable right angled with an terminating characteristic impedance (6) in order to build up a testing chamber for the system to be tested, which, preferably rightangled attached, with one or several return conductors is switched together, at which the magnitude of the terminating characteristic impedance (6) with, at the most a few ohm difference, correspond to the impulse generating wave guide (IGW).

2. Device after claim 1, is **characterized that** the terminating characteristic impedance (6) which is developed planar or is consisting of several single characteristic impedance's.

3. Device after claim 1 or 2, is **characterized that** several of the devices are switched together as modules in order to lengthen the testing chamber.

4. Device after claims 1 - 3, is **characterized that** the rail-shaped spark gap (4) is assigned for a tube with variable pressure.

5. Device after claims 1-4, is **characterized that** testing of the systems is practicable repeatingly in the range of nano seconds to seconds.

6. Device after claim 1, is **characterized that** the impulse generating wave guide (IGW) is arranged parallel to the return conductors with essentially the same characteristic wave impedance as the impulse-conducting wave guides (ICW).

## Revendications

1. Dispositif pour l'essai d'immunité EMV de la compatibilité électromagnétique en particulier des systèmes spatial grands, comme des wagons de chemin de fer et/ou trains avec des guides d'onde générants des impulsions (IEW) qui présentent des barres éléctroconducteurs (2) qui sont composés l'un à l'autre parallelement et interconnecté sur une electrode de tête qui sont en droite ligne raccordable sur une distance d'étincelle formée comme un rail (4) avec les guides d'onde qui dérivent l'impulsion (IFW), qui sont liés pour former un secteur d'essai pour le système à examiner, de préférence rectangulairement ensuite, avec une résistance de conclusion (6). Ce résistance de conclusion en retour est interconnectée de préférence rectangulairement avec un ou plusieurs rédirecteurs, en quoi le montant de la résistance de conclusion (6) avec tout au plus peu d'ohms différence correspond à cela des guide d'onde génération d'impulsion (IEW).

2. Dispositif après l'exigence 1, marqué du fait que la résistance de conclusion (6) est laminaire formée ou se compose de plusieur résistances particulières.

3. Dispositif après les exigences 1 ou 2, marqué du fait que plusieurs des dispositifs sont interconnnectés comme modules visant la prolongation du secteur d'essai.

4. Dispositif après les exigences 1 - 3, marqué du fait que la distance d'étincelle (4) formée comme un rail est prévue dans une canalisation alimentée avec la pression.

5. Dispositif après les exigences 1 - 4, marqué du fait que l'examen des systèmes est possible répétant dans le secteur des nanosecondes à des secondes.

6. Dispositif après l'exigence 1, marqué du fait que les guides d'onde génératns des impulsions (IEW) sont disposés parallèlement aux conduites de retour avec, en substance, la même résistance de vague que les guides d'onde qui dérivent l'impulsion IFW.
